(19) Europäisches Patentamt / European Patent Office / Office européen des brevets

(11) **EP 2 425 267 B1**

(12) **FASCICULE DE BREVET EUROPEEN**

(45) Date de publication et mention
de la délivrance du brevet:
**30.07.2014 Bulletin 2014/31**

(21) Numéro de dépôt: **10727027.4**

(22) Date de dépôt: **23.04.2010**

(51) Int Cl.:
*G01R 33/38* (2006.01)       *G01R 33/3815* (2006.01)
*G01R 33/385* (2006.01)      *G01R 33/421* (2006.01)

(86) Numéro de dépôt international:
**PCT/FR2010/050778**

(87) Numéro de publication internationale:
**WO 2010/125285 (04.11.2010 Gazette 2010/44)**

(54) **SYSTÈME D'IMAGERIE PAR RMN A PERTES CRYPTOGÉNIQUES ET BRUIT ACOUSTIQUE RÉDUITS**

NMR-BILDGEBUNGSSYSTEM MIT VERRINGERTEM KRYOGENISCHEN VERLUST UND AKUSTISCHEM RAUSCHEN

NMR IMAGING SYSTEM WITH REDUCED CRYOGENIC LOSSES AND ACOUSTIC NOISE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **27.04.2009 FR 0952746**

(43) Date de publication de la demande:
**07.03.2012 Bulletin 2012/10**

(73) Titulaire: **Commissariat à l'Énergie Atomique et aux Énergies Alternatives
75015 Paris (FR)**

(72) Inventeur: **AUBERT, Guy
F-86000 Poitiers (FR)**

(74) Mandataire: **Thévenet, Jean-Bruno et al
Cabinet Beau de Loménie
158, rue de l'Université
75340 Paris Cédex 07 (FR)**

(56) Documents cités:
**EP-A- 0 350 640       US-A- 6 107 799
US-B2- 6 707 302      US-B2- 7 514 928**

- **JAMES G SIMMONDS: "A SET OF SIMPLE, ACCURATE EQUATIONS FOR CIRCULAR CYLINDRICAL ELASTIC SHELLS" INTERNATIONAL JOURNAL OF SOLIDS AND STRUCTURES, NEW YORK, NY, US LNKD- DOI: DOI:10.1016/0020-7683(66)90036-9, vol. 2, no. 4, 1 janvier 1966 (1966-01-01), pages 525-541, XP007914392 ISSN: 0020-7683 cité dans la demande**

**Description**

Domaine de l'invention

La présente invention a pour objet un système d'imagerie par RMN (Résonance Magnétique Nucléaire) à pertes cryogéniques et bruit acoustique réduits.

L'invention concerne également un procédé de réduction du bruit acoustique et des pertes cryogéniques dans un système d'imagerie par résonance magnétique (IRM).

Art antérieur

Un exemple d'appareil d'imagerie par résonance magnétique est décrit par exemple dans le document de brevet EP 1 952 170 (référence [1]).

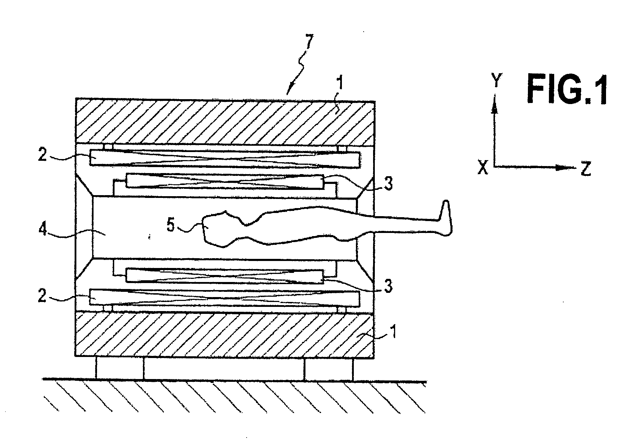

Un tel appareil d'IRM 7, représenté très schématiquement sur la figure 1, comprend essentiellement les éléments suivants :

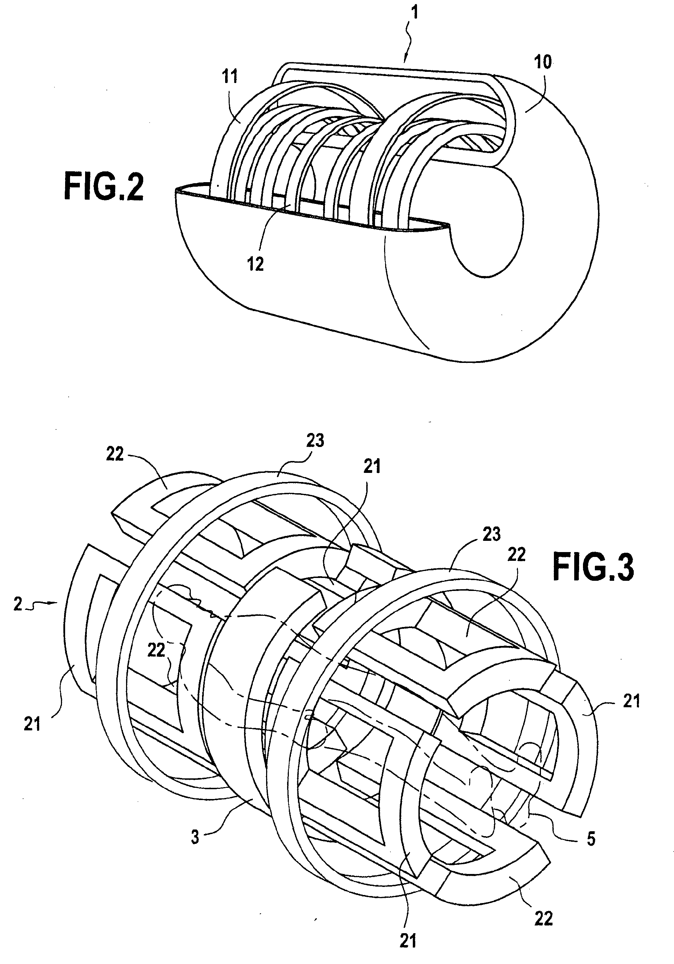

➢ un aimant 1 qui crée un champ magnétique principal $\vec{B}_0$ constant et sensiblement uniforme (on dit aussi homogène) dans une zone d'intérêt 4 (portion de l'objet ou du patient 5 à imager). Dans la plupart des appareils actuels cet aimant 1, comporte des bobinages supraconducteurs 11, 12 qui nécessitent pour fonctionner d'être refroidis à très basse température et sont pour ce faire plongés dans de l'hélium liquide dont la température d'ébullition sous la pression normale est 4,2 K. Ils sont donc contenus dans des réservoirs cryogéniques appropriés 10 (figure 2).

➢ un ensemble 2 de bobinages réalisés au moyen de conducteurs conventionnels (cuivre) destinés à produire des gradients du champ principal dans trois directions orthogonales de l'espace, soit $x$, $y$ et $z$, l'axe $Oz$ étant généralement la direction du champ principal. Ces gradients de champ sont appliqués suivant des séquences spécifiques qui permettent le codage spatial à l'origine de la construction d'images. Les processus d'imagerie par résonance magnétique impliquent que des courants très intenses (typiquement des centaines d'ampères) soient établis (ou supprimés) dans les bobines de gradient en des temps très courts (de l'ordre de la centaine de microsecondes) ou soient inversés, en des temps aussi courts, à des fréquences voisines du kilohertz comme dans les séquences dites d'imagerie echo-planar (EPI) ;

➢ une ou plusieurs antennes 3 d'émission et réception de signaux radiofréquence destinés à exciter et à détecter la précession des moments magnétiques nucléaires dans la zone d'intérêt à la fréquence correspondant à la valeur du champ magnétique local, par exemple 127,729 MHz environ pour les protons de l'eau dans un champ de 3 $T$.

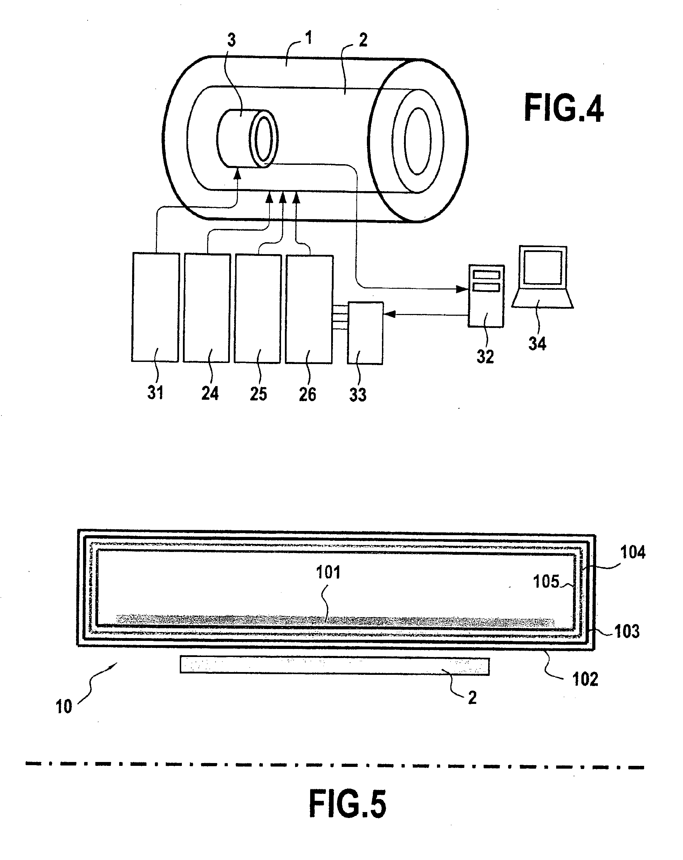

➢ des systèmes électroniques (amplificateurs 24 à 26 pour les gradients pulsés, générateurs et détecteurs radiofréquence 31...) et informatiques 32 à 34 (pilotage des séquences et reconstruction des images) (voir figure 4).

Les conducteurs des bobinages de gradient 21 à 23 (figure 3) sont soumis au champ magnétique principal $\vec{B}_0$ et quand ils sont parcourus par un courant subissent une force perpendiculaire aux directions du champ et du courant dite force de Laplace (ou de Lorentz). Comme les temps d'établissement, de suppression ou d'inversion de ces courants sont très courts, il s'agit de véritables chocs mécaniques qui sont à l'origine du bruit caractéristique de fonctionnement des appareils d'IRM.

Si le champ principal est faible et que les impulsions de gradient sont assez espacées, on entend un *tac, tac, talc...* tout à fait supportable. Mais les appareils modernes font appel à des champs principaux de plus en plus intenses *(3 T* dans les machines cliniques haut de gamme, 7 *T* dans quelques machines expérimentales et jusqu'à près de 12 *T* dans des machines en construction telles que celles mentionnées dans la référence [2:]), à des gradients également de plus en plus intenses et à des séquences d'imagerie très «violentes » (EPI par exemple). Les forces de Laplace subies par les gradients sont alors à l'origine non seulement d'un bruit acoustique quasi insupportable voire effrayant pour les patients qui doivent porter des protections auriculaires, mais aussi de vibrations mécaniques susceptibles d'endommager le système de gradients.

La référence [3] présente une synthèse récente de l'état de la question. On constate également une augmentation très significative des pertes cryogéniques, c'est-à-dire de l'évaporation d'hélium (voir la référence [4]).

On rappellera ci-dessous la structure schématique des enveloppes cryogéniques (cryostat 10) d'un aimant supraconducteur, celle d'un système 2 de gradients et les mécanismes qui sont à l'oeuvre dans des interactions gradients-aimant.

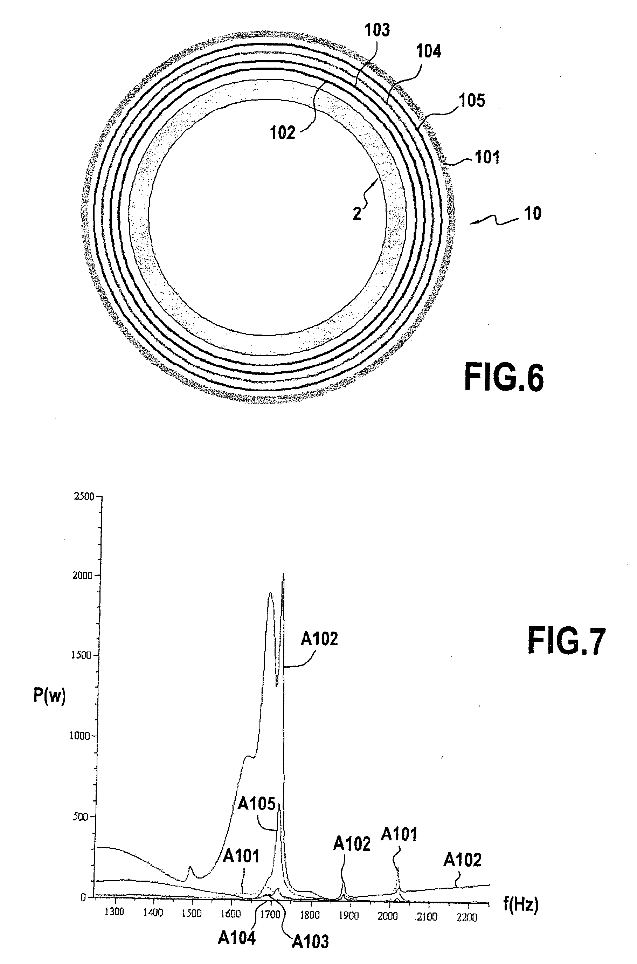

Les divers éléments du cryostat 10 sont des cylindres métalliques minces (quelques millimètres d'épaisseur pour un mètre de diamètre environ à l'intérieur et deux mètres à l'extérieur) raccordés par des fonds « bombés » pour constituer des espaces toriques de petite section axiale sensiblement rectangulaire (fig. 5 et 6). Seuls les cylindres intérieurs plus proches des gradients jouent un rôle significatif pour le problème considéré. On trouve ainsi, de l'intérieur vers l'extérieur :

> l'enceinte à vide 102 le plus souvent en acier inoxydable. C'est dans ce cylindre à température ambiante dit « *trou intérieur* » ou *"tunnel"* qu'est inséré le système générateur de gradients 2;

> un écran thermique 103 généralement en aluminium maintenu à une température de 80 *K* environ;

> éventuellement un second écran thermique 104 également en matériau bon conducteur de la chaleur et maintenu à environ 20 *K* ;

> le réservoir d'hélium 105 dit *« enceinte hélium »* ou *« boîte froide »* le plus souvent en acier inoxydable qui sera donc à la température d'ébullition de l'hélium soit 4,2 K sous la pression normale ou inférieure pour les aimants fonctionnant à plus basse température, dans de l'hélium superfluide par exemple;

> le mandrin 101 supportant les bobinages supraconducteurs 11, 12, généralement en alliage d'aluminium.

Dans le vocabulaire de la mécanique, ces enveloppes cylindriques minces (épaisseur faible devant le diamètre et la longueur) sont appelées des « *coques* ». Si les matériaux qui les constituent sont isotropes, ce qui est généralement le cas, ils sont caractérisés du point de vue mécanique par leur masse volumique $\rho$ et par deux constantes élastiques, le module d'élasticité ou module d'Young *E* et le coefficient de Poisson *V*. Dans les calculs mécaniques on utilise également les coefficients de Lamé :

$$\lambda = \frac{E\nu}{(1+\nu)(1-2\nu)}$$

$$\mu = \frac{E}{2(1+\nu)}$$

Le coefficient $\mu$ est aussi appelé module de cisaillement ou de rigidité et noté *G*.

Du point de vue électrique, ces matériaux sont caractérisés par leur conductivité électrique $\sigma$.

En ce qui concerne les gradients, la structure la plus simple est celle d'un gradient-z dont le modèle académique est connu sous le nom de spires de Maxwell, soit deux spires circulaires d'axe *Oz*, de rayon $a_0$, situées aux cotes

$\pm b_0 = \pm \dfrac{a_0\sqrt{3}}{2}$ et parcourues par des courants d'intensités opposées $\pm I$. Elles créent dans la zone d'intérêt au voisinage de l'origine *O* un gradient $G_z = \dfrac{\partial B_z}{\partial z}$ de la composante $B_z$ du champ sensiblement uniforme (on dit aussi linéaire par référence à la variation du champ). Ces spires de Maxwell sont l'équivalent, des spires de Helmholtz pour la génération d'un champ uniforme. Dans la pratique, les conducteurs ont des sections finies et l'on doit pouvoir évacuer la chaleur due à l'effet Joule, ce qui conduit à des nappes de courant de géométrie appropriée à la production d'un gradient possédant la linéarité souhaitée (V. par exemple le brevet FR 2 588 997 correspondant à la référence [5].

Les impulsions de courant dans les bobinages de gradients provoquent l'apparition, dans les conducteurs environnants (notamment les enveloppes du cryostat), de courants induits ou « *courants de Foucault* » dont il est important de limiter l'influence. L'un des moyens les plus efficaces pour ce faire est l'utilisation d'un « *écrantage* » ou « *blindage* » actif qui consiste à disposer un second ensemble de courants antagonistes à une certaine distance à l'extérieur des premiers, ce qui a pour inconvénient un certain encombrement et nécessite une puissance plus importante pour un gradient fixé. On trouvera des exemples de réalisation dans la référence [5]. Les forces magnétiques exercées par le champ principal sur les conducteurs générateurs de gradients-z tendent, suivant le sens des courants, soit à augmenter soit à réduire le rayon de bobinage, ce qui conduit à des modes de vibration relativement simples combinant des oscillations radiales et longitudinales suivant l'axe *Oz*.

La réalisation la plus courante des bobinages produisant des gradients $G_x = \dfrac{\partial B_z}{\partial x}$ ou $G_y = \dfrac{\partial B_z}{\partial y}$ de la composante $B_z$ du champ magnétique fait appel à des conducteurs en forme de selles de cheval ou « bobines de Golay » (fig. 3). La référence [5] en décrit une réalisation pratique et, comme pour un gradient-z, on peut réaliser un écrantage ainsi qu'expliqué dans le brevet FR 2 621 125 correspondant à la référence [6]. Les forces magnétiques tendent ici à incurver les cylindres porteurs des nappes de courant en forme de banane et les modes d'oscillation correspondants sont plus complexes que pour les gradients-z.

L'objet principal de la présente invention n'est pas de réduire ces vibrations propres au système de gradients : une conception alternative a été proposée par ailleurs dans ce but dans la référence [1]. Il s'adresse essentiellement à la réduction des courants de Foucault et des vibrations qu'induisent les gradients dans les enveloppes du cryostat et qui sont aujourd'hui reconnus comme l'une des causes majeures du bruit acoustique et des pertes cryogéniques.

Le mécanisme des interactions gradients-aimant est bien analysé qualitativement dans le brevet US 6 707 302 correspondant à la référence [7], ainsi que dans le brevet US 7 514 928 correspondant à la référence [8], qui propose des dispositions internes au cryostat susceptibles de diminuer leurs nuisances.

Une autre approche pour réduire les courants de Foucault et leurs conséquences nuisibles est proposée par les brevets US 7 141 974 et 7 375 526 correspondant à la référence [9] en complétant un écrantage actif déjà connu (cf. par exemple la référence [6]) par un écrantage passif au moyen d'une enveloppe supplémentaire en matériau bon conducteur comme le cuivre. L'amélioration obtenue par de tels systèmes ne s'avère cependant pas suffisante en pratique.

Une modélisation quantitative précise est donc nécessaire pour mieux appréhender l'incidence des divers paramètres et en déduire des dispositions pratiques.

Le système gradients-cryostat est gouverné par des équations aux dérivées partielles d'une part mécaniques et, d'autre part, électromagnétiques. En l'absence d'un champ principal $\vec{B_0}$, ces deux ensembles d'équations seraient indépendants et c'est leur couplage par le champ qui complique notablement le problème.

Une des façons d'écrire les équations mécaniques est la forme vectorielle de Lamé :

$$(\lambda + 2\mu)\,\overrightarrow{\mathrm{grad}}\,\mathrm{div}\,\vec{U} - \mu\,\overrightarrow{\mathrm{rot}}\,\overrightarrow{\mathrm{rot}}\,\vec{U} + \vec{F} = \rho\,\frac{d^2\vec{U}}{dt^2}$$

où $\vec{U}$ est le vecteur déplacement au point considéré et $\vec{F}$ la densité volumique de forces. En l'absence du champ principal celle-ci se réduirait au poids dont l'influence est sans importance pour ce problème, sinon pour dimensionner les supports des différents éléments, mais si ce champ existe et s'il y a des courants induits de densité volumique $\vec{J}$, on a un terme de couplage avec les équations électromagnétiques :

$$\vec{F} = \vec{J} \times \vec{B_0}$$

Les autres équations mécaniques qui ne seront pas explicitées ici sont relatives aux conditions aux limites sur les surfaces des divers éléments, notamment aux extrémités des tubes cylindriques constituant les enveloppes.

Comme pour les équations mécaniques, il existe plusieurs façons d'écrire les équations de l'électromagnétisme, la forme différentielle bien connue des équations de Maxwell par exemple ou la forme intégrale suivante :

$$\overrightarrow{J_M} = \sigma\left(-\frac{\partial \overrightarrow{A_M}}{\partial t} + \overrightarrow{E'_M} + \frac{d\overrightarrow{U_M}}{dt} \times \overrightarrow{B_0}\right)$$

$$\overrightarrow{A_M} = \overrightarrow{A_{0M}} + \overrightarrow{A'_M}$$

$$\overrightarrow{A'_M} = \frac{\mu_0}{4\pi} \iiint \frac{\overrightarrow{J_P}}{\left|\overrightarrow{PM}\right|} d\tau_P$$

$$\overrightarrow{E'_M} = \frac{1}{4\pi\varepsilon_0} \iiint \frac{Q_P \overrightarrow{PM}}{\left|\overrightarrow{PM}\right|^3} d\tau_P$$

$$\operatorname{div} \overrightarrow{J} + \frac{\partial Q}{\partial t} = 0$$

Dans ces équations, $\overrightarrow{J}_M$ est la densité des courants de Foucault en un point $M$ quelconque de chacune des enveloppes, $\overrightarrow{U_M}$ le vecteur déplacement et $\overrightarrow{A_M}$ le potentiel vecteur magnétique en ce même point. Ce dernier est la somme du potentiel vecteur $\overrightarrow{A_{0M}}$ créé par les courants des bobinages de gradients ou potentiel d'excitation et du potentiel vecteur $\overrightarrow{A'_M}$ créé au point $M$ par la totalité des courants de Foucault, l'intégration de la troisième équation étant étendue à tout le volume des enveloppes conductrices, $P$ en désignant le point courant. $Q_P$ est la densité volumique de charge électrique en un point quelconque $P$ et $\overrightarrow{E'_M}$ le champ électrique que crée cette distribution de charges au point $M$, avec $\mu_0 = 4\pi \times 10^{-7}$ $S.I.$ et $\varepsilon_0\mu_0 c^2 = 1$ où $c$ est la vitesse de la lumière dans le vide. La dernière équation valable en tout point exprime la conservation de la charge électrique. Pour ne pas compliquer l'écriture, les deux dernières équations ci-dessus sont données sous leur forme générique avec des densités volumiques de charge. En réalité, les densités de charge sont principalement superficielles, ce qui transforme l'intégrale de volume de l'avant dernière équation en intégrale de surface alors que la dernière équation se transforme en condition aux limites à la surface des conducteurs. Ces équations seraient les équations bien connues des problèmes de courants induits s'il n'y avait pas, dans la première équation, le terme de couplage avec les équations mécaniques par le champ principal, soit $\dfrac{d\overrightarrow{U_M}}{dt} \times \overrightarrow{B_0}$.

Ces équations sont en fait des équations approchées dans lesquelles on a négligé le courant dit de déplacement, approximation parfaitement justifiée si les dimensions du système (ici de l'ordre du mètre) sont petites devant la distance parcourue par la lumière dans un temps caractéristique de l'évolution du système (ici le temps de montée des impulsions de gradients, ce qui donne << 300 $m$ pour 1 $\mu s$). Cette approximation est bien connue en électromagnétisme sous le nom d'approximation des états quasi-stationnaires ou des régimes quasi-permanents.
La résolution de ces systèmes d'équations fait appel à des méthodes diverses (éléments finis, éléments de frontières, méthode des moments, méthodes spectrales ou pseudo-spectrales...) qui font l'objet d'une abondante littérature.
On ne cherche pas directement la réponse du système à une impulsion de gradients de forme quelconque mais la réponse à une excitation sinusoïdale de fréquence angulaire $\omega = 2\pi f$. Les équations étant linéaires, la réponse à une excitation de forme quelconque s'obtient alors par superposition des réponses aux composantes de Fourier de celle-ci.
S'il y a bien un théorème de superposition pour les déplacements et les densités de courant et de charge, les puissances dissipées qui s'expriment au moyen du carré des densités de courant doivent être calculées après que la somme des densités de courant a été effectuée si l'excitation n'est pas une sinusoïde pure.
Les phénomènes observés sont dominés par les modes de vibration des diverses coques en présence. Les vibrations des coques constituent un domaine étudié de façon extensive notamment pour l'aéronautique (avions, fusées...) et la marine (sous-marins...). On trouvera des informations à ce sujet dans les références [10] et [11].
Considérons selon un modèle simplifié l'exemple d'une seule coque cylindrique d'axe $Oz$, de rayon moyen $a$, d'épaisseur $e$ et de longueur $2b$. Elle est plongée dans un champ principal uniforme $\overrightarrow{B_0} = B_0 \overrightarrow{u_z}$ et excitée sinusoïdalement à la fréquence angulaire ω par un gradient-z schématisé par deux spires de Maxwell symétriques par rapport au plan médian *xOy* du cylindre qui produisent un gradient d'amplitude $G_0$ à l'origine.

Les modes de vibration possibles pour une coque cylindrique peuvent être très compliqués mais le mode le plus simple qualifié de « *respiratoire* » est une vibration purement radiale dont la fréquence angulaire est donnée par l'expression :

$$\omega_0 = 2\pi f_0 = \frac{1}{a}\sqrt{\frac{E}{\rho\left(1 - \nu^2\right)}}$$

pour un cylindre mince (cette fréquence est alors sensiblement indépendante de l'épaisseur) de rayon moyen *a*.

La période correspondante $\tau_0 = \dfrac{1}{f_0}$ est sensiblement le temps que mettrait une onde acoustique pour parcourir la circonférence du cylindre. C'est plus précisément un temps intermédiaire entre les temps mis par les deux types d'ondes susceptibles de se propager dans un solide, les ondes longitudinales ou de compression, les plus rapides, et les ondes transversales ou de cisaillement, les plus lentes.

Tous les modes de vibration susceptibles d'être excités dans la situation considérée ont des fréquences qui se déduisent de cette fréquence caractéristique en restant du même ordre de grandeur.

La situation est caractérisée par trois échelles de longueur, le rayon du cylindre *a*, son épaisseur *e* et l'épaisseur de peau caractéristique de la distribution des courants de Foucault à la fréquence considérée :

$$\delta = \sqrt{\frac{2}{\mu_0 \sigma \omega}}$$

notamment l'épaisseur de peau $\delta_0$ à la fréquence $\omega_0 = 2\pi f_0$ caractéristique du matériau du cylindre. Pour les matériaux usuels, cette fréquence $f_0$ est toujours de l'ordre de 1000 à 2000 *Hz* pour des cylindres de diamètre moyen égal à *1 m* :

| | |
|---|---|
| *Al* | 1704,6 |
| *Cu* | 1341,2 |
| *SS* | 1559,9 |

où *SS* désigne l'acier inoxydable (*"stainless steel"*).

La solution du problème serait simple si les conditions suivantes étaient replies :

$$e \ll \delta \ll a$$

mais ce n'est malheureusement pas le cas car pour les matériaux considérés : *e* et $\delta_0$ sont du même ordre de grandeur, soit millimétrique. La distribution des courants de Foucault dans l'épaisseur des enveloppes, ici du cylindre, qui n'est pas uniforme et dépend fortement de la fréquence et du couplage par $\overline{B}$ est alors un élément essentiel de la solution. On ne détaillera pas celle-ci (distribution de courant, composantes du déplacement...) et l'on présentera simplement la dissipation de puissance dans la totalité du cylindre en fonction de la fréquence (« *spectre de puissances*»). Vibrations, bruit acoustique et puissance dissipée sont en effet liés et réduire celle-ci réduira ceux-là de façon concomitante.

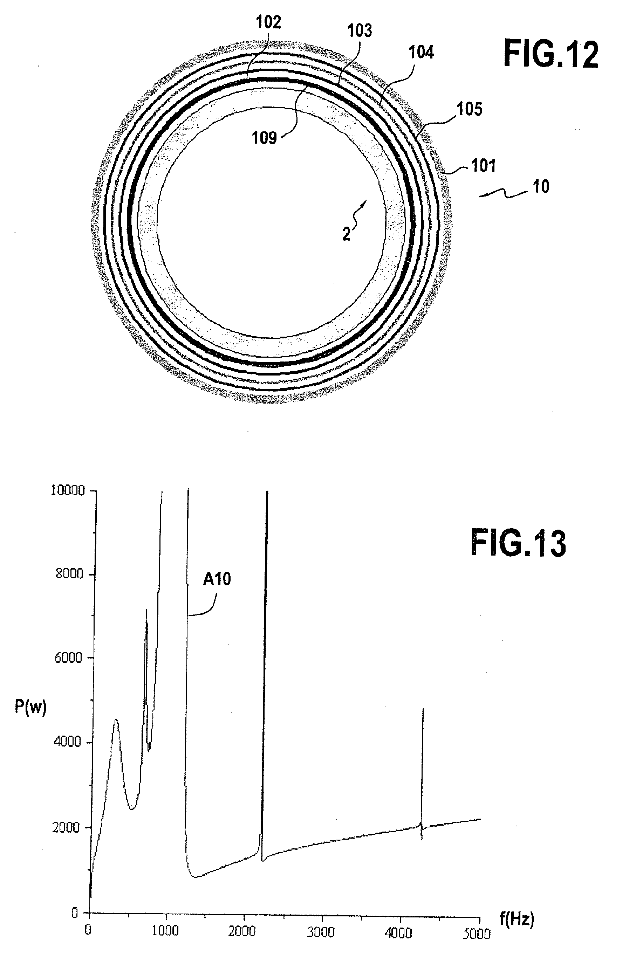

A titre d'exemple, la figure 13 montre le spectre de la puissance dissipée P en *W* en fonction de la fréquence f en *Hz* de l'excitation dans un cylindre en cuivre dont les caractéristiques sont les suivantes :

$$a = 0{,}45\,m,\ b = 1\,m,\ e = 5\,mm$$

$$\rho = 8960 \; kg/m^3, \; E = 138 \; GPa, \; \nu = 0,364, \; f_0 = 1490,244 \; Hz$$

$$\sigma = 58 \; MS/m \; (100\% \; IACS), \; \delta_0 = 1,712 \; mm$$

Le cylindre est simplement supporté et les extrémités sont totalement libres. Les spires de Maxwell ont un rayon $a_0$ = 0,3 $m$ et produisent un gradient d'amplitude $G_0$ = 100 $mT/m$ dans un champ principal $B_0$ = 11,75T.

L'homme de l'art dispose de toutes les données nécessaires à la vérification de ces résultats par les méthodes de son choix.

Toutefois, même dans une configuration aussi simple tant pour sa description que pour le calcul (les lignes de courant de Foucault sont des cercles d'axe $Oz$ et la densité de courant $\vec{J}$ se réduit à sa composante azimutale, les densités volumiques de charges sont identiquement nulles et le vecteur déplacement $\vec{U}$ a une composante radiale et une composante axiale ou longitudinale, sa composante azimutale étant nulle), le spectre est compliqué avec un pic très prononcé au voisinage de 1080 $Hz$ (voir la courbe A10 de la figure 13).

La théorie des coques cylindriques minces donne l'expression analytique exacte des fréquences propres pour une telle configuration si le cylindre est fermé par un fond à ses deux extrémités, fond qui bloque les déplacements radiaux et laisse libre les déplacements axiaux. Ces fréquences sont solutions de l'équation :

$$\Omega^4 - \Omega^2 \left\{ 1 + \left(\frac{m\pi a}{2b}\right)^2 \left[ 1 + \frac{1}{12}\left(\frac{m\pi e}{2b}\right)^2 \right] \right\} + \left(\frac{m\pi a}{2b}\right)^2 \left[ 1 - \nu^2 + \frac{a^2 e^2}{12}\left(\frac{m\pi}{2b}\right)^4 \right] = 0$$

où $\Omega = \dfrac{\omega}{\omega_0}$ et $m$ est un entier. Pour des extrémités libres, on a des fréquences légèrement voisines. Par exemple, les pics aux fréquences voisines de 2205 $Hz$ et 4250 $Hz$ correspondent à $m$ = 2 et $m$ = 4 respectivement.

Les puissances dissipées atteintes sont considérables ce qui démontre la nécessité d'un écrantage actif des gradients.

Le calcul est effectué dans le cadre de l'élasticité linéaire c'est à dire pour des oscillations de faible amplitude. Les valeurs obtenues par de tels calculs sont donc essentiellement théoriques et des phénomènes non linéaires allant jusqu'à des ruptures interviendront bien avant qu'elles soient atteintes.

Ces valeurs obtenues sont proportionnelles au carré de l'amplitude du gradient considéré et sont des fonctions croissantes du champ principal.

Si l'on considère maintenant un système réel avec un cryostat à quatre enveloppes 102 à 105 tel que celui des figures 5 et 6 et un mandrin de bobinage 101 dont le champ principal est 7 $T$ la figure 7 montre le spectre A101, A102, A103, A104, A105 des puissances dissipées respectivement dans chacune de ces enveloppes ou mandrin 101 à 105 quand elles sont sollicitées par un gradient-z d'amplitude 50 $mT/m$ soigneusement écranté : cet écrantage n'est jamais parfait et cet exemple correspond aux performances d'écrantage des meilleurs gradients du marché. Le spectre des puissances dissipées dans la boite froide 105 et le mandrin 101 correspond à l'origine de l'évaporation d'hélium.

Les gradients-x ou y conduisent à des résultats similaires avec des pics de formes et de position en fréquence légèrement différentes car les modes de vibration excités sont également différents.

Le bruit acoustique provient essentiellement des vibrations de la première enveloppe 102 en acier inoxydable (courbe A102) alors que les pertes d'hélium proviennent de l'énergie dissipée principalement dans la quatrième enveloppe (boîte froide 105 - courbe A105), la puissance (courbe A101) dissipée dans le mandrin de bobinage 101 étant nettement moins importante.

On voit qu'il est pratiquement impossible qu'une impulsion de gradient ou une séquence d'EPI n'ait pas une composante de Fourier qui excite une partie du spectre en induisant une dissipation de puissance significative et des vibrations importantes accompagnées de leur bruit acoustique. La fréquence fondamentale des séquences d'EPI couramment utilisées est en effet d'environ 600 à 700 $Hz,$ et le premier harmonique en importance est l'harmonique trois, soit 1800 à 2100 $Hz$ qui tombera dans la partie du spectre qu'il faudrait absolument éviter. Cette situation est bien mise en évidence expérimentalement (voir la référence [12]).

Les brevets US 6 707 302 et US 7 514 928 (références [7] et [8]) proposent de modifier les enveloppes du cryostat pour en réduire les vibrations et leurs conséquences. Ces modifications sont en concurrence avec d'autres impératifs mécaniques ou cryogéniques et leurs effets ne sont pas garantis a priori. Il est par ailleurs très difficile sinon impossible de modifier quoi que ce soit une fois que l'aimant est construit et le cryostat fermé.

La solution proposée par le brevet US 7 375 526 (référence [9]) consiste à insérer entre le système de gradients et le cylindre intérieur du cryostat un cylindre en matériau électriquement très bon conducteur tel que le cuivre.

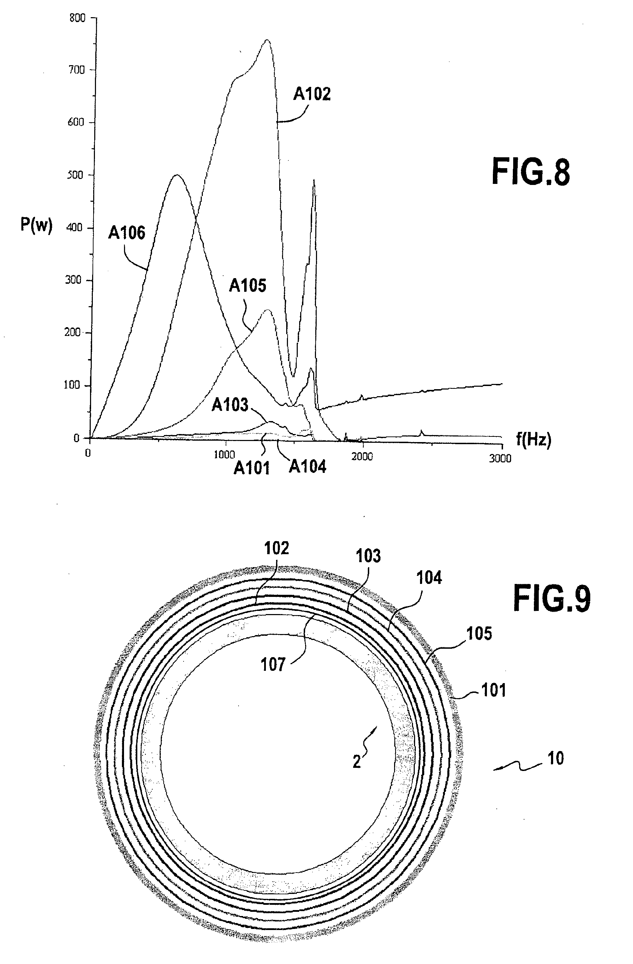

Si l'on considère le système de cryostat précédemment décrit et si l'on applique l'insertion d'un cylindre en cuivre de 10 *mm* d'épaisseur, on voit que cela conduit au spectre de la figure 8 où la courbe supplémentaire A106 est le spectre de la puissance dissipée dans ce cylindre en cuivre. On constate une amélioration sensible mais les pics très néfastes aux environs de 1000-1500 *Hz* n'ont pas disparu.

<u>Définition et objet de l'invention</u>

La présente invention vise à remédier aux inconvénients précités et à permettre une réduction plus importante du bruit acoustique et des pertes cryogéniques dans un appareil d'imagerie par résonance magnétique de façon simple et bon marché sans qu'il soit nécessaire de modifier l'ensemble de la conception de cet appareil.

Ces buts sont atteints conformément à l'invention grâce au système d'imagerie par résonance magnétique à pertes cryogéniques et bruit acoustique réduits de la revendication 1 et au

procédé de réduction du bruit acoustique et des pertes cryogéniques dans un système d'imagerie par résonance magnétique de la revendication 12.

Selon l'invention, on a ainsi reconnu la nécessité que l'enveloppe supplémentaire insérée entre les gradients et le tube intérieur du cryostat (ou les enveloppes successives insérées en fonction de la place disponible) doit posséder les propriétés suivantes :

➢ avoir une fréquence caractéristique $f_0$ aussi différente que possible de celles des enveloppes présentes dans le cryostat, ce qui n'est pas le cas des bons conducteurs habituels comme le cuivre recommandé par la référence [9] ;

➢ être un conducteur plutôt mauvais pour ne pas porter de courants de Foucault très importants, ce qui est tout à fait contraire aux préconisations de la référence [9].

<u>Brève description des dessins</u>

D'autres caractéristiques et avantages de l'invention ressortiront de la description suivante de modes particuliers de réalisation de l'invention donnés en référence aux dessins annexés, sur lesquels :

- la Figure 1 est une vue schématique en coupe axiale d'un exemple d'appareil d'imagerie par résonance magnétique auquel est applicable l'invention,
- la Figure 2 est une vue schématique en perspective avec arrachement montrant un exemple de cryostat utilisable dans un appareil d'imagerie par résonance magnétique tel que celui de la figure 1,
- la Figure 3 est une vue schématique en perspective d'un ensemble de bobines de gradient utilisable dans un appareil tel que celui de la figure 1,
- la Figure 4 est une vue schématique des dispositifs électroniques et informatiques de commande associés à un appareil d'IRM,
- la Figure 5 est une vue schématique en demi-coupe axiale d'un exemple de cryostat connu utilisable dans un appareil d'IRM,
- la Figure 6 est une section transversale du cryostat de la figure 6,
- la Figure 7 montre des courbes de spectre de puissance en fonction de la fréquence pour différents éléments constitutifs du cryostat des figures 5 et 6,
- la Figure 8 montre des courbes de spectre de puissance en fonction de la fréquence pour différents éléments constitutifs du cryostat des figures 5 et 6, auxquels il a été ajouté un cylindre en matériau électriquement très bon conducteur tel que le cuivre,
- la Figure 9 est une vue schématique en section transversale d'un premier exemple de cryostat utilisable dans un appareil d'imagerie par résonance magnétique selon l'invention, avec une enveloppe supplémentaire mécaniquement libre,

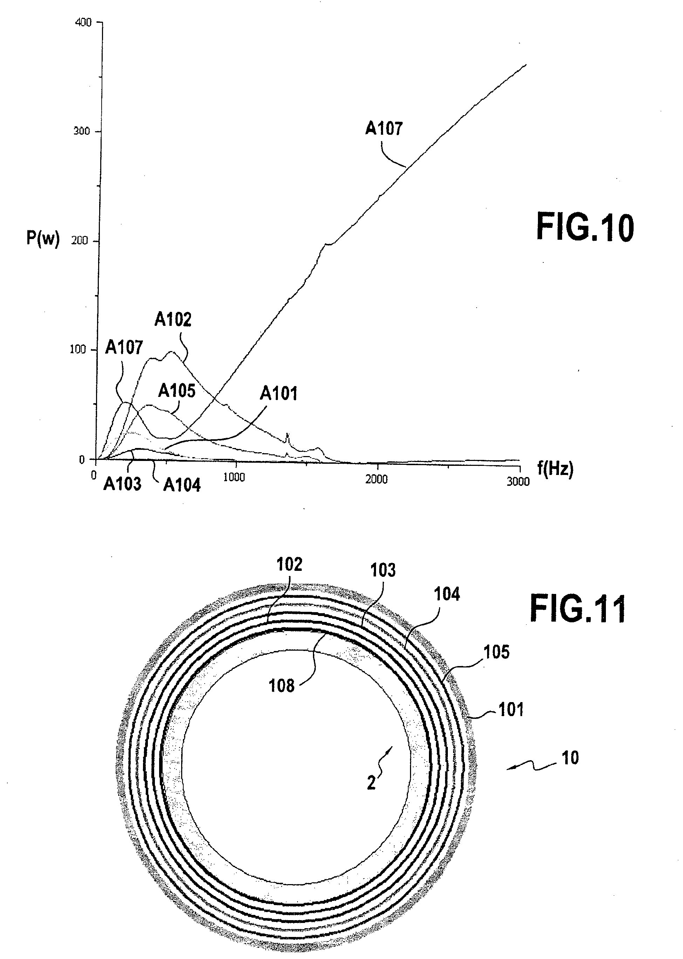

- la Figure 10 montre des courbes du spectre de puissance en fonction de la fréquence pour différents éléments constitutifs du cryostat de la figure 9,
- la Figure 11 est une vue schématique en section transversale d'un deuxième exemple de cryostat utilisable dans un appareil d'imagerie par résonance magnétique selon l'invention, avec une enveloppe supplémentaire mécaniquement liée à un ensemble de bobines de gradient,
- la Figure 12 est une vue schématique en section transversale d'un troisième exemple de cryostat utilisable dans un appareil d'imagerie par résonance magnétique selon l'invention, avec une enveloppe supplémentaire mécaniquement liée à une enceinte à vide, et

- la Figure 13 montre une courbe de spectre de puissance en fonction de la fréquence pour un exemple théorique comprenant un cylindre de cuivre.

<u>Description détaillée de modes de réalisation préférentiels</u>

L'invention s'applique à des systèmes 7 d'imagerie par résonance magnétique tels que ceux qui ont été décrits plus haut en référence aux figures 1 à 6 et qui mettent en oeuvre un cryostat 10 comprenant une enceinte à vide 102, par exemple en acier inoxydable, à l'intérieur de laquelle est disposé à température ambiante un système 2 générateur de gradients, au moins un écran thermique 103, 104 en matériau bon conducteur de la chaleur, tel que l'aluminium, et une boîte froide 105, par exemple en acier inoxydable, qui est à la température d'ébullition de l'hélium, soit 4,2 K.

Les enveloppes 102 à 105 sont concentriques. La boîte froide 105 incorpore un mandrin 101 qui supporte les bobinages supraconducteurs, par exemple en alliage d'aluminium constituant l'aimant 1 qui crée un champ magnétique principal.

Le système 2 de gradients, qui interagit avec le cryostat 10, peut être réalisé comme montré schématiquement sur la figure 3 avec des bobines 21 de gradient selon une direction X, des bobines 22 de gradient selon une direction Y perpendiculaire à la direction X et des bobines 23 de gradient selon une direction Z perpendiculaire aux directions X et Y et alignée avec l'axe de la machine d'imagerie. Ce système 2 de gradients ne sera donc pas décrit à nouveau.

Les divers éléments 102 à 105 constituant le cryostat 10 sont des cylindres métalliques minces (présentant quelques millimètres d'épaisseur pour un mètre de diamètre environ à l'intérieur et deux mètres à l'extérieur) raccordés par des fonds bombés pour constituer des espaces toriques de petite section axiale sensiblement rectangulaire (voir la figure 5). De telles enveloppes constituent des coques à différentes températures.

A titre d'exemple, sur la figure 9, on a une enceinte à vide 102 à la température ambiante, un premier écran thermique 103 à une température de 80 k environ, un deuxième écran thermique 104 à une température d'environ 20 K et un réservoir d'hélium ou boîte froide 105 à la température d'ébullition de l'hélium, soit 4,2 K. Le mandrin 101 et les bobines supraconductrices constituant l'aimant 1 sont également à la température d'ébullition de l'hélium.

Selon l'invention, on insère entre le système 2 de gradients et le cylindre intérieur 102 du cryostat 10 au moins une enveloppe cylindrique supplémentaire 107 qui présente les propriétés suivantes :

➢ avoir une fréquence caractéristique $f_0$ aussi différente que possible de celles des autres enveloppes 102 à 105 présentes dans le cryostat, ce qui n'est pas le cas des bons conducteurs habituels comme le cuivre recommandé par la référence [9];

➢ être un conducteur plutôt mauvais pour ne pas porter de courants de Foucault très importants, ce qui est également tout à fait contraire aux préconisations de la référence [9].

On peut insérer plusieurs enveloppes successives supplémentaires possédant les mêmes propriétés, par exemple deux ou trois enveloppes supplémentaires 107, en fonction de la place disponible. Toutefois, une seule enveloppe apporte déjà un bénéfice considérable et n'implique pas de modifier toute la structure préexistante du cryostat.

Pour répondre à la première des caractéristiques requises pour l'enveloppe supplémentaire 107, l'expression de $f_0$ donnée plus haut montre qu'il faut utiliser des matériaux à faible module d'Young et à masse volumique élevée ou l'inverse. On trouve ainsi les fréquences caractéristiques en *Hz*, toujours rapportées à des cylindres de 1 *m* de diamètre :

| | |
|---|---|
| *Be* | 3968,8 |
| *Pb* | 421,0 |
| *Sn* | 892,3 |
| *U* | 1080,8 |

Les deux premiers matériaux possèdent les fréquences les plus « anormales » mais la toxicité du béryllium et de ses composés en interdit pratiquement l'utilisation. Ce matériau doit donc être exclu. Par ailleurs sa résistivité de 4 $\times 10^{-8}$ $\Omega.m$ serait trop faible pour le second critère. Le plomb est au contraire tout à fait approprié avec une résistivité assez grande de $21 \times 10^{-8}$ $\Omega.m$ et la possibilité de « régler » à la fois la fréquence caractéristique et la résistivité à leurs valeurs optimales en réalisant des alliages de plomb avec de l'étain, du bismuth ou du cadmium notamment. Des exemples de propriétés des alliages de plomb sont donnés par exemple dans les références [13] et [14].

A titre de variante de réalisation, l'enveloppe supplémentaire 107 peut être réalisée en étain qui présente une fréquence caractéristique de 892,3 Hz, pour un cylindre de 1 *m* de diamètre et une résistivité de 10 X $10^{-8}$ $\Omega.m$. Par ailleurs, l'uranium appauvri présente des difficultés de mise en oeuvre et une fréquence caractéristique qui reste trop élevée (1080,8 Hz pour un cylindre de 1m de diamètre).

Dans le mode de réalisation de la figure 9, on met en oeuvre une enveloppe intermédiaire supplémentaire 107 tubulaire non liée mécaniquement au système 2 de gradients ou à l'enceinte à vide 102 du cryostat pour éviter toute transmission directe des vibrations.

A titre d'exemple, l'enveloppe intermédiaire supplémentaire 107 peut être constituée par un cylindre en plomb ordinaire avec les dimensions suivantes : rayon moyen 0,44 *m* épaisseur 10 *mm* et longueur 3,6 *m.* On obtient alors les spectres de dissipation d'énergie de la figure 10 qui montrent une réduction spectaculaire des effets nuisibles des gradients et notamment la disparition des pics au voisinage de 1000-1500 *Hz* par rapport à des appareils de l'art antérieur sans enveloppe supplémentaire (figure 7) ou avec une enveloppe cylindrique réalisée en un matériau très conducteur tel que le cuivre (voir la figure 8 et la courbe A106 correspondant au spectre de la puissance dissipée dans un cylindre de cuivre).

Sur la figure 10, la courbe A107 est le spectre de la puissance dissipée dans le cylindre en plomb 107. Ce spectre de puissance A107 montre que la puissance dissipée dans le cylindre de plomb 107 reste inférieure à environ 200W jusqu'à une fréquence de l'ordre de 1700 Hz, mais produit une réduction drastique de la puissance pour tous les spectres de puissance A101 à A105 des autres enveloppes 101 à 105.

En particulier, le spectre de puissance A102 lié à la première enveloppe 102 en acier inoxydable, qui est habituellement la principale responsable du bruit acoustique, ne présente plus qu'un pic de l'ordre de 100W vers 500 Hz alors que dans un système de l'art antérieur sans enveloppe supplémentaire (voir figure 7), ce pic est compris entre 1300 et 2000W autour de 1700 Hz et que même avec l'insertion d'une enveloppe conductrice en cuivre comme préconisé par la référence [9] (voir la figure 8), on trouve encore un pic de l'ordre de 750 W vers 1200 Hz.

De la même manière, avec un système selon la présente invention, grâce à la présence d'une enveloppe cylindrique supplémentaire en plomb, le pic de dissipation du spectre de puissance A105 de la boîte froide 105 (voir la figure 10) n'est plus que d'environ 50 W à une fréquence de l'ordre de 400 Hz tandis que dans un système de l'art antérieur sans enveloppe supplémentaire (voir figure 7), ce pic est de l'ordre de 600 W autour de 1700 Hz et que même avec l'insertion d'une enveloppe conductrice en cuivre comme préconisé par la référence [9] (voir la figure 8), on trouve encore un pic de l'ordre de 250 W vers 1300 Hz.

Les résultats sont d'autant meilleurs que la résistivité électrique de l'enveloppe supplémentaire 107 est élevée, mais il ne faut évidemment pas aller jusqu'à choisir un matériau isolant qui n'aurait aucun effet. Ceci signifie que pour une machine donnée (gradients et cryostat) il existe un choix optimal du couple ($f_0$,σ) parmi les matériaux disponibles. On peut également ajuster la longueur du cylindre 107 ainsi que son épaisseur aux fins d'obtenir le meilleur résultat pour des gradients et un cryostat donnés.

En règle générale, pour des systèmes d'IRM classiques, l'enveloppe supplémentaire 107 peut comprendre une structure tubulaire présentant un rayon moyen compris entre 0,4 et 0,5 m, une épaisseur comprise entre 8 et 12 mm et une longueur comprise entre 2 et 4 m.

Le mode de réalisation de la figure 9 met en oeuvre un tube intermédiaire 107 non lié mécaniquement au système 2 de gradients ou au cryostat 10 pour éviter toute transmission directe des vibrations. Cependant, selon un autre mode de réalisation possible, un cylindre de plomb ou équivalent 108, peut être lié mécaniquement à l'ensemble 2 des bobinages des gradients pour modifier et surtout réduire leurs vibrations propres (figure 11).

On peut également lier mécaniquement (par exemple par collage ou soudage) au tube intérieur 102 du cryostat 10 une couche cylindrique de plomb ou équivalent 109 pour modifier ses propriétés vibrationnelles (figure 12).

Pour un ensemble bobines 2 de gradients -cryostat 10 donné, la meilleure configuration comportant un ou plusieurs cylindres de plomb 107, 108 ou 109, liés mécaniquement ou non aux bobines 2 de gradient ou au tube intérieur 102 du cryostat 10 peut être déterminée par une modélisation selon les méthodes mentionnées plus haut.

Un mode de réalisation préférentiel demeure un tube intermédiaire 107 mécaniquement libre en plomb ou alliage de fréquence caractéristique $f_0$ aussi basse que possible et de résistivité électrique au moins aussi grande que celle du plomb.

Une réalisation avec un tube intermédiaire en étain ou en alliage d'étain constitue une solution alternative un peu moins performante mais qui procure néanmoins une amélioration notable en ce qui concerne la réduction du bruit acoustique et des pertes cryogéniques par comparaison avec des modes de réalisation mettant en oeuvre des tubes en cuivre ou autre matériau électriquement très bon conducteur.

Références citées

[1] Brevet EP 1 952 170, Guy Aubert,

[2] The Whole Body 11.7 T MRI Magnet for Iseult/INUMAC Project, Vedrine, P.; Aubert, G.; Beaudet, F.; Belorgey, J.; Beltramelli, J.; Berriaud, C.; Bredy, P.; Chesny, P.; Donati, A.; Gilgrass, G.; Grunblatt, G.; Juster, F.P.; Molinie, F.; Meuris, C.; Nunio, F.; Payn, A.; Quettier, L.; Rey, J.M.; Schild, T.; Sinanna, A., IEEE Transactions on Applied Superconductivity, vol.18, no.2, pp.868-873, June 2008.

[3] MRI Acoustic Noise : Sources and Mitigation, William A. Edelstein, ISMRM High Field Workshop, March 25-28, 2007.

[4] Problems of measurement of the helium boil off rate of tomographic magnets, Pavel Hanzelka & Jaroslav Horky, Cryogenics 39, pp. 647-649, 1999.

[5] Brevet FR2588997, Guy Aubert.

[6] Brevet FR2621125, Guy Aubert.

[7] Brevet US6707302, Guenter Riess.

[8] Brevet US7514928, Michael Westphal.

[9] Brevets US7141974 et US7375526, William A. Edelstein et al..

[10] An improved first-approximation theory for thin shells, J. Lyell Sanders, Jr, NASA, 1959.

[11] A set of simple, accurate équations for circular cylindrical elastic shells, James G. Simmonds, Int. J. Solids Structures, 1966, vol 2 pp 525-541

[12] Echo Planar Imaging at 4 Testa With Minimum, Acoustic Noise, D. G. Tomasi & T. Ernst, Journal of magnetic resonance imaging, 18, pp. 128-130, 2003.

[13] http://www.indium.com/products/alloychart.php

[14] Structure, mechanical properties and electrical resistivity of rapidly solidified Pb-Sn-Cd and Pb-Bi-Sn-Cd alloy, Mustafa Kamal, Abu Bakr El-Blediwi, Mohamed Bashir Karman, Journal of material science, materials in electronics 9, pp. 425-428, 1998.

## Revendications

1. Système d'imagerie par résonance magnétique à pertes cryogéniques et bruit acoustique réduits, comprenant des bobines supraconductrices (1) de création d'un champ magnétique principal $\overrightarrow{B_0}$ dans un espace intérieur utile (4) en forme de tunnel d'axe Z, des moyens (3) d'excitation radiofréquence et de traitement des signaux radiofréquence émis en réponse par un corps (5) ou objet disposé dans ledit espace intérieur utile (4), un ensemble (2) de bobines de -gradient solénoïdales pour superposer au champ magnétique principal $\overrightarrow{B_0}$ des composantes d'un champ magnétique supplémentaire, lesdites bobines de gradient étant disposées dans un espace annulaire cylindrique situé entre une enceinte cryogénique extérieure (10) contenant lesdites bobines supraconductrices (1) de création d'un champ magnétique principal $\overrightarrow{B_0}$ et ledit espace intérieur utile (4), et des circuits électroniques de commande (31-34, 24-26), l'enceinte cryogénique extérieure (10) de forme torique définissant ledit espace intérieur utile à température ambiante en forme de tunnel d'axe Z dans lequel est disposé l'ensemble (2) de bobines de gradient solénoïdales, l'enceinte cryogénique extérieure (10) comprenant successivement à partir dudit espace intérieur utile (4) une enceinte à vide (102), au moins un premier écran thermique (103) maintenu à une température comprise entre 20 K et 80 K, un réservoir d'hélium (105) à une température inférieure à 5 K et un mandrin (101) de support des bobines supraconductrices (1) de création d'un champ magnétique principal $\overrightarrow{B_0}$, l'enceinte cryogénique extérieure (10) comprenant en outre au moins une enveloppe supplémentaire (107 ; 108 ; 109) interposée entre l'ensemble (2) de bobines de gradient solénoïdales et l'enceinte à vide (102), l'enveloppe supplémentaire (107 ; 108 ; 109) étant en un matériau conducteur de résistivité électrique supérieure ou égale à $7 \times 10^{-8}\ \Omega m$, présentant une fréquence caractéristique de vibration purement radiale inférieure ou égale à celle de chacun des autres éléments constitutifs précités de l'enceinte cryogénique extérieure (10), **caractérisé en ce que** ledit matériau conducteur est constitué en l'un des matériaux suivants : plomb, étain, alliage d'étain, alliage de plomb et de l'un au moins des éléments comprenant : l'étain, le bismuth et le cadmium.

2.  Système selon la revendication 1, **caractérisé en ce que** l'enveloppe supplémentaire (107) est constituée par un tube disposé entre l'ensemble (2) de bobines de gradient solénoïdales et l'enceinte à vide (102) sans être lié mécaniquement à ceux-ci.

3.  Système selon la revendication 1, **caractérisé en ce que** l'enveloppe supplémentaire (108) est constituée par un tube lié mécaniquement à l'ensemble (2) de bobines de gradient solénoïdales.

4.  Système selon la revendication 1, **caractérisé en ce que** l'enveloppe supplémentaire (109) est constituée par un tube lié mécaniquement à l'enceinte à vide (102).

5.  Système selon la revendication 4, **caractérisé en ce que** l'enveloppe supplémentaire (109) est constituée par un tube lié mécaniquement à l'enceinte à vide (102) par collage ou soudage.

6.  Système selon l'une quelconque des revendications 1 à 5, **caractérisé en ce que** l'enceinte cryogénique (10) comprend outre ledit premier écran thermique (103) maintenu à une température comprise entre 20 K et 80 K, un deuxième écran thermique (104) maintenu à une température inférieure ou égale à 20 K.

7.  Système selon l'une quelconque des revendications 1 à 6, **caractérisé en ce que** ledit au moins un premier écran thermique (103, 104) est en aluminium ou en alliage d'aluminium.

8.  Système selon l'une quelconque des revendications 1 à 7, **caractérisé en ce que** l'enceinte à vide (102) et le réservoir d'hélium (105) sont en acier inoxydable.

9.  Système selon l'une quelconque des revendications 1 à 8, **caractérisé en ce que** ledit mandrin (101) est en aluminium ou en alliage d'aluminium.

10. Système selon l'une quelconque des revendications 1 à 8, **caractérisé en ce que** l'enveloppe supplémentaire (107 ; 108 ; 109) comprend une structure tubulaire présentant un rayon moyen compris entre 0,4 et 0,5 m, une épaisseur comprise entre 8 et 12 mm et une longueur comprise entre 2 et 4 m.

11. Système selon l'une quelconque des revendications 1 à 10, **caractérisé en ce qu'**il comprend au total deux ou trois enveloppes supplémentaires concentriques (107 ; 108 ; 109) interposées entre l'ensemble (2) de bobines de gradient solénoïdales et l'enceinte à vide (102), et présentant chacune les caractéristiques de ladite enveloppe supplémentaire (107 ; 108 ; 109).

12. Procédé de réduction du bruit acoustique et des pertes cryogéniques dans un système d'imagerie par résonance magnétique comprenant des bobines supraconductrices (1) de création d'un champ magnétique principal $\overrightarrow{B_0}$ dans un espace intérieur utile (4) en forme de tunnel d'axe Z , des moyens (3) d'excitation radiofréquence et de traitement des signaux radiofréquence émis en réponse par un corps (5) ou objet disposé dans ledit espace intérieur utile (4), un ensemble (2) de bobines de gradient solénoïdales pour superposer au champ magnétique principal $\overrightarrow{B_0}$ des composantes d'un champ magnétique supplémentaire, lesdites bobines de gradient étant disposées dans un espace annulaire cylindrique situé entre une enceinte cryogénique extérieure (10) contenant lesdites bobines supraconductrices (1) de création d'un champ magnétique principal $\overrightarrow{B_0}$ et ledit espace intérieur utile (4), et des circuits électroniques de commande (31-34, 24-26), l'enceinte cryogénique extérieure (10) de forme torique définissant ledit espace intérieur utile à température ambiante en forme de tunnel d'axe Z dans lequel est disposé l'ensemble (2) de bobines de gradient solénoïdales, l'enceinte cryogénique extérieure (10) comprenant successivement à partir dudit espace intérieur utile (4) une enceinte à vide (102), au moins un premier écran thermique (103) maintenu à une température comprise entre 20 K et 80 K, un réservoir d'hélium (105) à une température inférieure à 5 K et un mandrin (101) de support des bobines supraconductrices (1) de création d'un champ magnétique principal $\overrightarrow{B_0}$, ledit procédé comprenant une étape consistant à insérer dans l'enceinte cryogénique extérieure (10) au moins une enveloppe supplémentaire (107 ; 108 ; 109) interposée entre l'ensemble (2) de bobines de gradient solénoïdales et l'enceinte à vide (102), l'enveloppe supplémentaire (107 ; 108 ; 109) étant en un matériau conducteur de résistivité électrique supérieure ou égale à 7x10⁻⁸ $\Omega m$, présentant une fréquence caractéristique de vibration purement radiale inférieure ou égale à celle de chacun des autres éléments constitutifs précités de l'enceinte cryogénique extérieure (10), **caractérisé en ce que** ledit matériau conducteur est constitué en l'un des matériaux suivants : plomb, étain, alliage d'étain, alliage de plomb et de l'un au moins des éléments comprenant : l'étain, le bismuth et le cadmium.

**Patentansprüche**

1. Magnetresonanz-Bildgebungssystem mit verringerten kryogenen Verlusten und akustischen Geräuschen, umfassend Supraleitspulen (1) zur Erzeugung eines Hauptmagnetfeldes $B_0$ in einem Nutzinnenraum (4) in Form eines Tunnels mit der Achse Z, Mittel (3) zur Funkfrequenzerregung und Bearbeitung der Funkfrequenzsignale, die als Antwort von einem Körper (5) oder Objekt, das in dem Nutzinnenraum (4) angeordnet ist, entsandt werden, eine Einheit (2) von Solenoidgradientenspulen, um das Hauptmagnetfeld $B_0$ mit Komponenten eines zusätzlichen Magnetfeldes zu überlagern, wobei die Gradientenspulen in einem zylindrischen ringförmigen Raum angeordnet sind, der sich zwischen einem äußeren kryogenen Raum (10), der die Supraleitspulen (1) zur Erzeugung eines Hauptmagnetfeldes $B_0$ enthält, und dem Nutzinnenraum (4) befindet, und elektronische Steuerschaltungen (31 - 34, 24 - 26), wobei der äußere kryogene Raum (10) in Ringform den Nutzinnenraum mit Raumtemperatur in Tunnelform mit der Achse Z definiert, in dem die Einheit von Solenoidgradientenspulen (2) angeordnet ist, wobei der äußere kryogene Raum (10) nacheinander vom Nutzinnenraum (4) ausgehend einen Vakuumraum (102), mindestens einen ersten Wärmebildschirm (103), der auf einer Temperatur zwischen 20 K und 80 K gehalten wird, einen Heliumbehälter (105) mit einer Temperatur unter 5 K und einen Stützdorn (101) für die Supraleitspulen (1) zur Erzeugung eines Hauptmagnetfeldes $B_0$ umfasst, wobei der äußere kryogene Raum (10) ferner mindestens eine zusätzliche Hülle (107; 108; 109) umfasst, die zwischen der Einheit (2) von Solenoidgradientenspulen und dem Vakuumraum (102) angeordnet ist, wobei die zusätzliche Hülle (107; 108; 109) aus einem leitenden Material mit einer elektrischen Widerstandsfähigkeit größer oder gleich $7 \times 10^{-8}$ Ωm ist, das eine rein radiale charakteristische Vibrationsfrequenz kleiner oder gleich jener jedes der anderen vorgenannten Bestandteile des äußeren kryogenen Raums (10) aufweist, **dadurch gekennzeichnet, dass** das leitende Material aus einem der folgenden Materialien besteht: Blei, Zinn, Zinnlegierung, Bleilegierung und mindestens einem der Elemente, umfassend: Zinn, Wismut und Cadmium.

2. System nach Anspruch 1, **dadurch gekennzeichnet, dass** die zusätzliche Hülle (107) von einem Rohr gebildet ist, das zwischen der Einheit (2) von Solenoidgradientenspulen und dem Vakuumraum (102) angeordnet ist, ohne mit diesen mechanisch verbunden zu sein.

3. System nach Anspruch 1, **dadurch gekennzeichnet, dass** die zusätzliche Hülle (108) von einem Rohr gebildet ist, das mechanisch mit der Einheit (2) von Solenoidgradientenspulen verbunden ist.

4. System nach Anspruch 1, **dadurch gekennzeichnet, dass** die zusätzliche Hülle (109) von einem Rohr gebildet ist, das mechanische mit dem Vakuumraum (102) verbunden ist.

5. System nach Anspruch 4, **dadurch gekennzeichnet, dass** die zusätzliche Hülle (109) von einem Rohr gebildet ist, das mechanisch mit dem Vakuumraum (102) durch Kleben oder Schweißen verbunden ist.

6. System nach einem der Ansprüche 1 bis 5, **dadurch gekennzeichnet, dass** der kryogene Raum (10) außer dem ersten Wärmebildschirm (103), der auf einer Temperatur zwischen 20 K und 80 K gehalten wird, einen zweiten Wärmebildschirm (104) umfasst, der auf einer Temperatur kleiner oder gleich 20 K gehalten wird.

7. System nach einem der Ansprüche 1 bis 6, **dadurch gekennzeichnet, dass** der mindestens eine Wärmebildschirm (103, 104) aus Aluminium oder einer Aluminiumlegierung ist.

8. System nach einem der Ansprüche 1 bis 7, **dadurch gekennzeichnet, dass** der Vakuumraum (102) und der Heliumbehälter (105) aus rostfreiem Stahl sind.

9. System nach einem der Ansprüche 1 bis 8, **dadurch gekennzeichnet, dass** der Dorn (101) aus Aluminium oder einer Aluminiumlegierung ist.

10. System nach einem der Ansprüche 1 bis 8, **dadurch gekennzeichnet, dass** die zusätzliche Hülle (107; 108; 109) eine röhrenförmige Struktur umfasst, die einen durchschnittlichen Radius zwischen 0,4 und 0,5 m, eine Dicke zwischen 8 und 12 mm und eine Längs zwischen 2 und 4 m aufweist.

11. System nach einem der Ansprüche 1 bis 10, **dadurch gekennzeichnet, dass** es insgesamt zwei oder drei zusätzliche konzentrische Hüllen (107; 108; 109) umfasst, die zwischen der Einheit (2) von Solenoidgradientenspulen und der Vakuumeinheit (102) angeordnet sind und jeweils die Merkmale der zusätzlichen Hülle (107; 108; 109) aufweisen.

12. Verfahren zur Verringerung der akustischen Geräusche und der kryogenen Verluste in einem Magnetresonanz-Bildgebungssystem, umfassend Supraleitspulen (1) zur Erzeugung eines Hauptmagnetfeldes $B_0$ in einem Nutzinnenraum (4) in Form eines Tunnels mit der Achse Z, Mittel (3) zur Funkfrequenzerregung und Bearbeitung der Funkfrequenzsignale, die als Antwort von einem Körper (5) oder Objekt, das in dem Nutzinnenraum (4) angeordnet ist, entsandt werden, eine Einheit (2) von Solenoidgradientenspulen, um das Hauptmagnetfeld $B_0$ mit Komponenten eines zusätzlichen Magnetfeldes zu überlagern, wobei die Gradientenspulen in einem zylindrischen ringförmigen Raum angeordnet sind, der sich zwischen einem äußeren kryogenen Raum (10), der die Supraleitspulen (1) zur Erzeugung eines Hauptmagnetfeldes $B_0$ enthält, und dem Nutzinnenraum (4) befindet, und elektronische Steuerschaltungen (31-34, 24-26), wobei der äußere kryogene Raum (10) in Ringform den Nutzinnenraum mit Raumtemperatur in Tunnelform mit der Achse Z definiert, in dem die Einheit von Solenoidgradientenspulen (2) angeordnet ist, wobei der äußere kryogene Raum (10) nacheinander vom Nutzinnenraum (4) ausgehend einen Vakuumraum (102), mindestens einen ersten Wärmebildschirm (103), der auf einer Temperatur zwischen 20 K und 80 K gehalten wird, einen Heliumbehälter (105) mit einer Temperatur unter 5 K und einen Stützdorn (101) für die Supraleitspulen (1) zur Erzeugung eines Hauptmagnetfeldes $B_0$ umfasst, wobei das Verfahren einen Schritt umfasst, der darin besteht, in den äußeren kryogenen Raum (10) mindestens eine zusätzliche Hülle (107; 108; 109) einzusetzen, die zwischen der Einheit (2) von Solenoidgradientenspulen und dem Vakuumraum (102) angeordnet ist, wobei die zusätzliche Hülle (107; 108; 109) aus einem leitenden Material mit einer elektrischen Widerstandsfähigkeit größer oder gleich $7 \times 10^{-8}$ $\Omega$m ist, das eine rein radiale charakteristische Vibrationsfrequenz kleiner oder gleich jener jedes der anderen vorgenannten Bestandteile des äußeren kryogenen Raums (10) aufweist, **dadurch gekennzeichnet, dass** das leitende Material aus einem der folgenden Materialien besteht: Blei, Zinn, Zinnlegierung, Bleilegierung und mindestens einem der Elemente, umfassend: Zinn, Wismut und Cadmium.

## Claims

1. A magnetic resonance imaging system with reduced cryogenic losses and acoustic noise, the system including superconducting windings (1) for creating a main magnetic field $\overrightarrow{B_0}$ in a useful internal space (4) in the form of a tunnel with axis Z, means (3) for radio-frequency excitation and processing of radio-frequency signals emitted in response by a body (5) or object placed in said useful internal space (4), a set (2) of solenoid gradient windings for superposing on the intense main magnetic field $\overrightarrow{B_0}$ components of an additional magnetic field, said gradient windings being placed in a cylindrical annular space situated between an external cryogenic enclosure (10) containing said superconducting windings (1) for creating a main magnetic field $\overrightarrow{B_0}$ and said useful internal space (4), and electronic control circuits (31-34, 24-26), the toroidal external cryogenic enclosure (10) defining said useful internal space at room temperature in the form of a tunnel with axis Z in which there is placed the set (2) of solenoid gradient windings, said external cryogenic enclosure (10) successively comprising from said useful internal space (4) a vacuum enclosure (102), at least one first heat shield (103) maintained at a temperature in the range 20 K to 80 K, a helium reservoir (105) at a temperature less than 5 K, and a former (101) for supporting the superconducting windings (1) for creating a main magnetic field $\overrightarrow{B_0}$, the external cryogenic enclosure (10) further including at least one additional envelope (107; 108; 109) placed between the set (2) of solenoid gradient windings and the vacuum enclosure (102), the additional envelope (107; 108; 109) being made of a conductive material with electrical resistivity greater than or equal to $7 \times 10^{-8}$ $\Omega$.m and having a characteristic frequency of purely radial vibration less than or equal to the characteristic frequencies of each of the other components of the external cryogenic enclosure (10), **characterized in that** said conductive material is made of one of the following materials: lead, tin, tin alloy, alloy of lead and at least one of the following elements: tin, bismuth, cadmium.

2. A system according to claim 1, **characterized in that** the additional envelope (107) is constituted by a tube located between the set (2) of solenoid gradient windings and the vacuum enclosure (102) without being mechanically connected thereto.

3. A system according to claim 1, **characterized in that** the additional envelope (108) is constituted by a tube that is mechanically connected to the set (2) of solenoid gradient windings.

4. A system according to claim 1, **characterized in that** the additional envelope (109) is constituted by a tube that is mechanically connected to the vacuum enclosure (102).

5.  A system according to claim 4, **characterized in that** the additional envelope (109) is constituted by a tube that is mechanically connected to the vacuum enclosure (102) by gluing or welding.

6.  A system according to any one of claims 1 to 5, **characterized in that** the cryogenic enclosure (10) includes in addition to said first heat shield (103) maintained at a temperature less than or equal to 80 K, a second heat shield (104) maintained at a temperature less than or equal to 20 K.

7.  A system according to any one of claims 1 to 6, **characterized in that** said at least a first heat shield (103, 104) is made of aluminum or aluminum alloy.

8.  A system according to any one of claims 1 to 7, **characterized in that** the vacuum enclosure (102) and the helium reservoir (105) are made of stainless steel.

9.  A system according to any one of claims 1 to 8, **characterized in that** said former (101) is made of aluminum or aluminum alloy.

10. A system according to any one of claims 1 to 8, **characterized in that** the additional envelope (107; 108; 109) includes a tubular structure having a mean radius in the range 0.4 m to 0.5 m, thickness in the range 8 mm to 12 mm, and a length in the range 2 m to 4 m.

11. A system according to any one of claims 1 to 10, **characterized in that** it includes two or three concentric additional envelopes (107; 108; 109) which are interposed between the set (2) of solenoid gradient windings and the vacuum enclosure (102) and each present the characteristics of said additional envelope (107; 108; 109).

12. A method of reducing acoustic noise and cryogenic losses in a magnetic resonance imaging system including superconducting windings (1) for creating a main magnetic field $\overrightarrow{B_0}$ in a useful internal space (4) in the form of a tunnel with axis Z, means (3) for radio-frequency excitation and processing of radio-frequency signals emitted in response by a body (5) or object placed in said useful internal space (4), a set (2) of solenoid gradient windings for superposing on the main magnetic field $\overrightarrow{B_0}$ components of an additional magnetic field, said gradient windings being placed in a cylindrical annular space situated between an external cryogenic enclosure (10) containing said superconducting windings (1) for creating an intense main magnetic field $\overrightarrow{B_0}$ and said useful internal space (4), and electronic control circuits (31-34, 24-26), the toroidal external cryogenic enclosure (10) defining said internal cylindrical space at room temperature in the form of a tunnel of axis Z in which there is placed the set (2) of solenoid gradient windings, the external cryogenic enclosure (10) successively comprising from said useful internal space (4) a vacuum enclosure (102), at least a first heat shield (103) maintained at a temperature in the range 20 K to 80 K, an helium reservoir (105) at a temperature less than 5 K, and a former (101) for supporting the superconducting windings (1) for creating a main magnetic field $\overrightarrow{B_0}$, said method including a step of inserting in the external cryogenic enclosure (10) at least one additional envelope (107; 108; 109) placed between the set (2) of solenoid gradient windings and the vacuum enclosure (102), the additional envelope (107; 108; 109) being made of a conductive material with electrical resistivity greater than or equal to $7 \times 10^{-8}$ Ω.m and having a characteristic frequency of purely radial vibration less than or equal to the characteristic frequencies of each of said other components of the external cryogenic enclosure (10), **characterized in that** said conductive material is made of one of the following materials: lead, tin, tin alloy, alloy of lead and at least one of the following elements: tin, bismuth, cadmium.

FIG.1

**FIG.2**

**FIG.3**

FIG.4

FIG.5

FIG.6

FIG.7

FIG.8

FIG.9

FIG.10

FIG.11

FIG.12

FIG.13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1952170 A
- FR 2588997
- FR 2621125
- US 6707302 B
- US 7514928 B
- US 7141974 B
- US 7375526 B

**Littérature non-brevet citée dans la description**

- **VEDRINE, P. ; AUBERT, G. ; BEAUDET, F. ; BELORGEY, J. ; BELTRAMELLI, J. ; BERRIAUD, C. ; BREDY, P. ; CHESNY, P. ; DONATI, A. ; GILGRASS, G.** The Whole Body 11.7 T MRI Magnet for Iseult/INUMAC Project. *IEEE Transactions on Applied Superconductivity,* Juin 2008, vol. 18 (2), 868-873
- **WILLIAM A. EDELSTEIN.** MRI Acoustic Noise : Sources and Mitigation. *ISMRM High Field Workshop,* 25 Mars 2007
- **PAVEL HANZELKA ; JAROSLAV HORKY.** Problems of measurement of the helium boil off rate of tomographic magnets. *Cryogenics,* 1999, vol. 39, 647-649
- **J. LYELL SANDERS, JR.** An improved first-approximation theory for thin shells. *NASA,* 1959
- **JAMES G. SIMMONDS.** A set of simple, accurate équations for circular cylindrical elastic shells. *Int. J. Solids Structures,* 1966, vol. 2, 525-541
- **D. G. TOMASI ; T. ERNST.** Echo Planar Imaging at 4 Testa With Minimum, Acoustic Noise. *Journal of magnetic resonance imaging,* 2003, vol. 18, 128-130
- **MUSTAFA KAMAL ; ABU BAKR EL-BLEDIWI ; MOHAMED BASHIR KARMAN.** Structure, mechanical properties and electrical resistivity of rapidly solidified Pb-Sn-Cd and Pb-Bi-Sn-Cd alloy. *Journal of material science, materials in electronics,* 1998, vol. 9, 425-428